(19) Europäisches Patentamt
European Patent Office
Office européen des brevets

(11) EP 1 471 586 A1

(12) **EUROPEAN PATENT APPLICATION**

(43) Date of publication:
**27.10.2004 Bulletin 2004/44**

(51) Int Cl.[7]: **H01L 51/20**

(21) Application number: **04009729.7**

(22) Date of filing: **23.04.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **25.04.2003 JP 2003122623**

(71) Applicant: **Pioneer Corporation**
**Meguro-ku, Tokyo (JP)**

(72) Inventor: **Ohta, Satoru**
**Tsurugashima-shi Saitama (JP)**

(74) Representative:
**Reinhard - Skuhra - Weise & Partner GbR**
**Postfach 44 01 51**
**80750 München (DE)**

(54) **Process for the production of organic transistor and organic transistor**

(57) A process for the production of an organic transistor comprises a step of forming a surface-treated layer on a gate insulating layer and a step of forming an organic semiconductor layer on the surface-treated layer. In the process, a step of irradiating the gate insulating layer with ultraviolet rays in an ozone atmosphere before the formation of the surface-treated layer is involved.

*FIG. 2A*

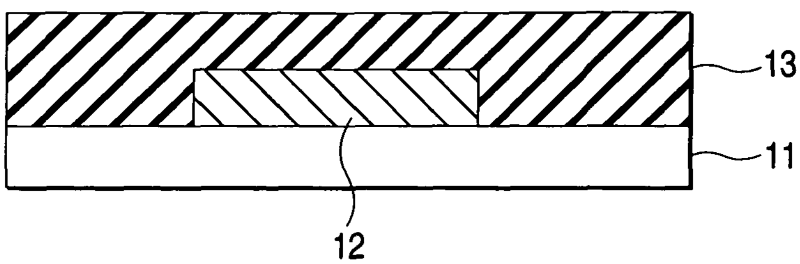


EP 1 471 586 A1

FIG. 2B

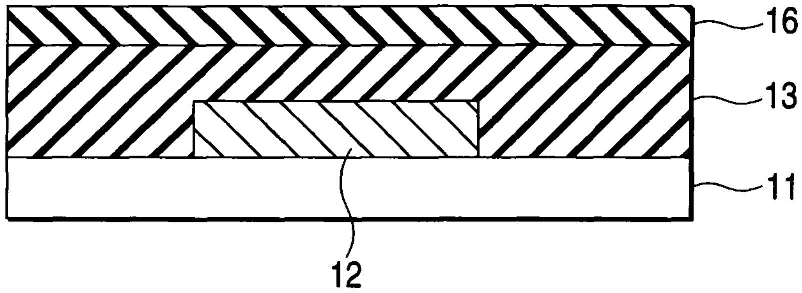


FIG. 2C

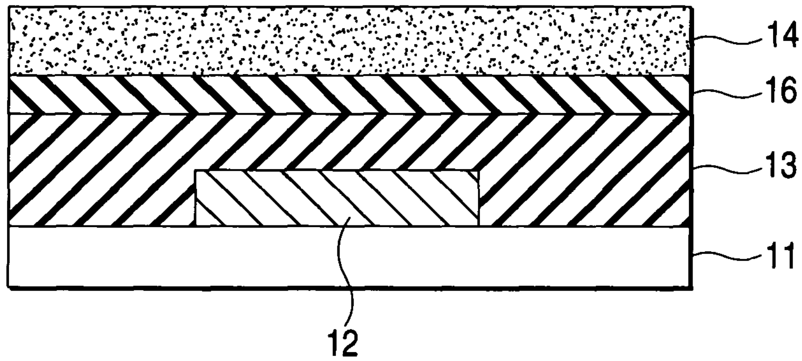


FIG. 2D

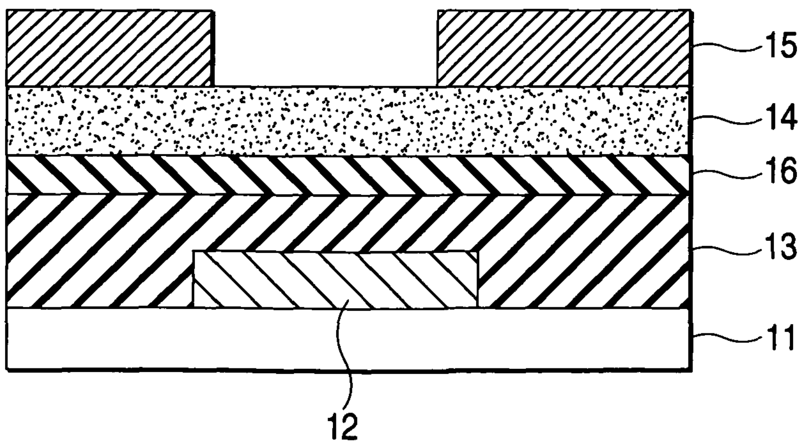

## Description

### BACKGROUND OF THE INVENTION

1. Field of the Invention

The present invention relates to a process for the production of an organic transistor and an organic transistor.

2. Description of the Related Art

In the production of an organic transistor, a vacuum evaporation process or a wet process such as spin coating method and casting method has heretofore been practiced to form an organic semiconductor layer directly on a gate insulating layer (for example, JP-A-2001-94107).

As an example of an organic semiconductor element, a structure of an organic MIS-based TFT (thin film transistor) will be described below.

An organic MIS-based TFT comprises a gate electrode, a gate insulating layer, a source electrode, a drain electrode and an organic semiconductor layer provided on a substrate. Referring to a material of various layers constituting the organic MIS-based TFT, the gate electrode is made of nickel, chromium, ITO or the like. The gate insulating layer is made of a silicon compound such as $SiO_2$ and SiN or metal oxide or nitride. The organic semiconductor layer is made of pentacene orthelike. The source and drain electrode are made of palladium, gold or the like.

Referring to process for formation of the gate insulating layer, if an inorganic material is used, RF (DC) sputtering method, CVD method or the like is often used. Alternatively, in order to form an insulating layer having a good quality uniformly on the gate electrode, anodization may be effected with a metal capable of forming an oxide having a high dielectric constant such as Al and Ta as a gate electrode.

In production of an organic transistor comprising a gate insulating layer made of silicon oxide and an organic semiconductor made of pentacene, for example, a thin pentacene layer is formed directly on the gate insulating layer by a vacuum deposition method.

In order to produce an organic transistor having a high mobility and a good quality, it is essential to consider a adhesion between an interface of a gate insulating layer and an organic semiconductor layer during the formation of the organic semiconductor layer on the gate insulating layer. In general, however, a metal oxide layer such as $SiO_2$ has a high surface energy. In general, an organic semiconductor, which is hydrophobic, wets little such a metal oxide layer. Thus, in an attempt to enhance the wettability of the gate insulating layer by the organic semiconductor, it has been practiced to modify the surface energy of the gate insulating layer with a surface treatment such as octadecyl trichlorosilane (OTS) and hexamethyldisilazalane (HMDS).

### SUMMARY OF THE INVENTION

However, the related art process for the production of an organic transistor is disadvantageous in that since the surface of $SiO_2$ which is a gate insulating layer has little hydroxyl groups necessary for surface treatment distributed thereon and these hydroxyl groups, if any, are not uniformly distributed, the surface treatment is not uniformly effected, causing the scattering of surface energy and hence making it impossible to stably form an organic semiconductor layer having a high mobility.

The problems that the invention is to solve include the aforementioned problems with the related art process for the production of an organic transistor.

In order to solve the aforementioned problems, a process for production of an organic transistor comprises forming a surface-treated layer on a gate insulating layer and forming an organic semiconductor layer on the surface-treated layer, wherein the gate insulating layer is irradiated with ultraviolet rays in an ozone atmosphere before the formation of the surface-treated layer.

### BRIEF DESCRIPTION OF THE DRAWING

Fig. 1 is a typical sectional view illustrating the structure of a top contact type organic MIS-based TFT;
Fig. 2A to Fig.2D are a flow chart illustrating a process for the production of a top contact type organic MIS-based TFT which is an organic transistor according to an embodiment of implementation of the invention; and
Fig. 3 is a typical sectional view illustrating the structure of a bottom contact type organic MIS-based TFT.

DETAILED DESCRITPION OF THE PREFFERD EMBODIMENTS

Embodiments of implementation of the invention will be described hereinafter in connection with the drawings.

A process for the production of an organic transistor according to the invention is characterized in that the surface treatment which is a pretreatment for the formation of an organic semiconductor layer is preceded by a step of irradiation of the gate insulating layer with ultraviolet rays in an ozone atmosphere by which organic contaminants are removed from the surface of the gate insulating layer and a large number of hydroxyl groups reactive with a surface active agent are uniformly produced on the surface of the gate insulating layer. The present embodiment of implementation of the invention will be further described by referring to an organic MIS-based TFT as an example of organic semiconductors.

Fig. 1 is a typical sectional view illustrating structure of a top contact type organic MIS-based TFT produced by a process for production of an organic transistor according to an embodiment of implementation of the invention. As shown in Fig. 1, an organic MIS-based TFT 100 comprises a gate electrode 12, a gate insulating layer 13, an organic semiconductor layer 14 and a source and a drain electrode 15 provided on a substrate 11.

The substrate 11 may be a glass or plastic substrate. The gate insulating layer may be formed by $SiO_2$, $Ta_2O_5$, $TiO_2$, $Nb_2O_5$ or $Al_2O_3$. The gate electrode 12 and the source and drain electrode 15 may be formed by tantalum, aluminum, Rh, Ir, Ni, Pd, Pt, Au, As, Se, Te, Al, Cu, Ag, Mo, W, Mg, Zn or the like. However, the invention is not limited to these materials. Alternatively, alloys of these metals may be used.

The organic semiconductor layer 14 may be formed by a conjugated hydrocarbon polymer such as polyacetylene, polydiacetylene, polyacene and polyphenylene vinylene, a derivative containing an oligomer of these conjugated hydrocarbon polymers, a conjugated heterocyclic polymer such as polyaniline, polythiophene, polypyrrole, polyfurane, polypyridine and polychenylene vinylene, a derivative containing an oligomer of these conjugated heterocyclic polymers or the like.

In other words, the organic semiconductor layer may be formed by a condensed aromatic hydrocarbon such as tetracene, chrysene, pentacene, pyrene, perylene and coronene, derivative thereof or metal complex of porphyrin and phthalocyanine compound such as copper phthalocyanine and ruthenium bisphthalocyanine.

An example of a process for production of an organic transistor according to an embodiment of implementation of the invention will be described in connection with a flow sheet.

Fig. 2A to Fig. 2D are a flow chart illustrating a process for production of a top contact type organic MIS-based TFT according to the present embodiment of implementation of the invention.

Firstly, substrate 11 as a silicon wafer which has a gate electrode 12 formed thereon by a known method is subjected to thermal oxidation to form an $SiO_2$ gate insulating layer 13 thereon (Fig. 2A).

Subsequently, the gate insulating layer 13 is irradiated with ultraviolet rays in an ozone atmosphere (UV irradiation step).

Thereafter, the substrate is allowed to dip in a stock solution of hexamethyldisilazalane (HMDS), dip in toluene under application of ultrasonic wave so that unreacted HMDS is removed, and then dried (HMDS treatment). At this point, a surface-treated layer 16 is formed on the gate insulating layer (Fig. 2B).

Subsequently, pentacene is vacuum-deposited on the dried substrate to form an organic semiconductor layer 14 (Fig. 2C) . Subsequently, the substrate is vacuum-coated with gold to form a source and drain electrode 15. Thus, a top contact type organic transistor 100 is completed (Fig. 2D).

The substrate temperature at which the organic semiconductor layer 14 is formed as shown in Fig. 2C will be described hereinafter. It is generally known that as the substrate temperature during vacuum deposition rises, the state of the organic semiconductor layer changes frombulk to lamellar, causing rise of mobility of the organic transistor. Thus, the mobility of the organic transistor can be enhanced by properly controlling the substrate temperature. But, on the contrary, as temperature is raised too high, defect increases in the layer, so that vapor-deposition have to be conducted in an appropriate range of the substrate temperature.

The surface-treated layer 16 formed after the aforementioned UV irradiation step may be formed by a mono- or trichlorosilane compound or mono- or trialkoxysilane compound having a functional group containing at least 8 or more carbon atoms represented by the following chemical formula instead of hexamethyldisilazalane (HMDS).

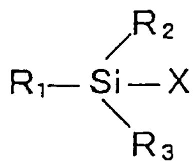

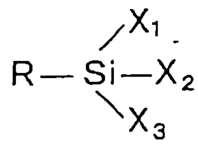

wherein $R_1$ or R each independently represents a functional group having 8 or more carbon atoms containing hydrogen, oxygen, nitrogen, sulfur or halogen; X represents a chlorine atom, methoxy group or ethoxy group; $X_1$, $X_2$ and $X_3$ each independently represent a chlorine atom, methoxy group or ethoxy group; and $R_2$ and $R_3$ each independently represents an alkyl group having at least one carbon atoms.

Examples of the monochlorosilane compound include dimethyloctylchlorosilane, dimethyl-2-(4-cyclohexenylethyl)chlorosilane, dimethyl-β-phenethyl trichlorosilane, dimethylchloromethylphenylethyl chlorosilane, dimethylnonylchlorosilane, dimethyl heptadecafluorodecylchlorosilane, dimethyldecylchloro silane, dimethyldodecylchlorosilane, dimethyltetradecyl chlorosilane, dimethyloctadecylchlorosilane, dimethyl eicosilchlorosilane, and dimethyldocosilchlorosilane.

Examples of the trichlorosilane compound include octyltrichlorosilane, 2-(4-cyclohexenylethyl) trichlorosilane, β-phenetyltrichlorosilane, chloromethyl phenylethyltrichlorosilane, nonyltrichlorosilane, heptadecafluorodecyltrichlorosilane, decyltrichlorosilane, dodecyltrichlorosilane, tetradecyltrichlorosilane, octadecyltrichlorosilane, eicosiltrichlorosilane, and docosiltrichlrosilane.

Examples of the monomethoxysilane compound include dimethyloctylmethoxysilane, dimethyl-2-(4-cyclohexenylethyl)methoxysilane, dimethyl-β-phenethyl methoxysilane, dimethylchloromethylphenylethylmethoxy silane, dimethylnonylmethoxysilane, dimethylheptadecafluorodecylmethoxysilane, dimethyldecyl methoxysilane, dimethyldodecylmethoxysilane, dimethyl tetradecylmethoxysilane, dimethyloctadecylmethoxysilane, dimethyleicosilmethoxysilane, and dimethyldocosilmethoxy silane.

Examples of the trimethoxysilane compound include octyltrimethoxysilane, 2-(4-cyclohexenylethyl)trimethoxy silane, β-phenethyltrimethoxysilane, chloromethylphenyl ethyltrimethoxysilane, nonyltrimethoxysilane, heptadecafluorodecyltrimethoxysilane, decyltrimethoxy silane, dodecyltrimethoxysilane, tetradecyltrimethoxy silane, octadecyltrimethoxysilane, eicosiltrimethoxy silane, and docosiltrimethoxysilane.

Examples of the monoethoxysilane compound include dimethyloctylethoxysilane, dimethyl-2-(4-cyclohexenyl ethyl)ethoxysilane, dimethyl-β-phenethylethoxysilane, dimethylchloromethylphenylethylethoxysilane, dimethyl nonylethoxysilane, dimethylheptadecafluorodecylethoxy silane, dimethyldecylethoxysilane, dimethyldodecylethoxy silane, dimethyltetradecylethoxysilane, dimethyloctadecyl ethoxysilane, dimethyleicosilethoxysilane, and dimethyl docosilethoxysilane.

Examples of the triethoxysilane compound include octyltriethoxysilane, 2-(4-cyclohexenylethyl)triethoxy silane, β-phenethyltriethoxysilane, chloromethylphenyl ethyltriethoxysilane, nonyltriethoxysilane, heptadecafluorodecyltriethoxysilane, decyltriethoxysilane, dodecyltriethoxysilane, tetradecyltriethoxysilane, octadecyltriethoxysilane, eicosiltriethoxysilane, and docosilgtriethoxysilane.

Examples of actual production of organic transistors by the production process according to the present embodiment of implementation of the invention will be described hereinafter to make comparison with comparative examples involving no UV irradiation.

(Examples 1 - 5)

At the step shown in Fig. 2A, a silicon wafer substrate 11 which had a gate electrode 12 formed thereon by a known method was subjected to thermal oxidation to form a gate insulating layer 13 thereon to a thickness of 1,100 angstrom.

At the step shown in Fig. 2B, the aforementioned substrate was irradiated with ultraviolet rays for 20 minutes in an ozone atmosphere.

Thereafter, the substrate was allowed to stand dipped in a stock solution of hexamethyldisilazalane (HMDS), dipped in toluene under the application of ultrasonic wave for 10 minutes so that unreacted HMDS was removed, and then dried (HMDS treatment).

HMDS treatment was conducted in all the examples except Example 5.

Subsequently, at the step shown in Fig. 2C, the substrate thus dried was vacuum-coated with pentacene at a pressure of $2 \times 10^{-6}$ torr and a deposition rate of from 0.4 to 0.6 angstrom/s to a thickness of 500 angstrom to form

an organic semiconductor layer 14 thereon.

The substrate temperature was as follows:

Example 1: 20°C
Example 2: 40°C
Example 3: 70°C
Example 4: 120°C
Example 5: 20°C

Subsequently, at the step shown in Fig. 2D, the substrate was vacuum-coated with gold at a pressure of 2 x $10^{-6}$ torr and a deposition rate of from 1.0 to 1.5 angstrom/s to a thickness of 1, 000 angstrom to form a source electrode and a drain electrode 15. Thus, a top contact type organic transistor 100 having a channel length of 100 μm and a channel width of 5.0 mm was completed.

(Comparative Example)

At the step shown in Fig. 2B, the production procedure of Examples 1 to 4 was followed except that no UV irradiation step was conducted. The substrate temperature at the step shown in Fig. 2C was 40°C.

Mobility of the organic semiconductor layers produced in Examples 1 to 4 and Comparative Example were measured. The measurements are set forth in Table 1 below.

Table 1

| Example No. | Substrate temperature | Mobility | UV irradiation conducted ? | HMDS treatment conducted ? |
|---|---|---|---|---|
| Example 1 | 20°C | 0.47 $cm^2/Vs$ | Yes | Yes |
| Example 2 | 40°C | 0.52 $cm^2/Vs$ | Yes | Yes |
| Example 3 | 70°C | 0.79 $cm^2/Vs$ | Yes | Yes |
| Example 4 | 120°C | 0.32 $cm^2/Vs$ | Yes | Yes |
| Example 5 | 20°C | 0.12 $cm^2/Vs$ | Yes | No |
| Comparative Example | 40°C | 0.21 cm2/Vs | No | Yes |

For determination of the mobility of the organic semiconductor layer, drain current was measured at a gate voltage of 30 V. The mobility of the organic semiconductor layer was then calculated in the drain current saturation range using the following equation:

$$Id = (\mu CW /2L) \times (Vg - Vth)^2$$

where Id is the drain current, μ is the hole mobility, C is the capacitance of the insulating layer, L is the channel length, Vg is the gate voltage, and Vth is the threshold voltage.

As can be seen in the measurements shown in Table 1, it is preferred that the substrate temperature is adjusted to a range of from 40°C to 70°C to produce an organic transistor having a mobility of 0.5 $cm^2/Vs$ or more.

As a modification of the present embodiment of implementation of the invention, there may be exemplified a bottom contact type organic MIS-based TFT 200, which is another example of an organic transistor. Fig. 3 illustrates a typical sectional view of the bottom contact type organic MIS-based TFT 200.

For the production of the aforementioned modification, the order of formation of the organic semiconductor layer 14 and the source and drain electrode 15 may be inverted. The other steps may be the same as in the aforementioned examples.

The formation of the organic semiconductor layer in the aforementioned examples can be accomplished by a vacuum evaporation method involving resistance heating, a co-evaporation method using a plurality of evaporation sources, a sputtering method, a CVD method or the like.

The organic semiconductor layer may be a doped thin film or a multi-layered thin film made of a plurality of organic semiconductor materials instead of thin film made of a single material.

As mentioned above, the process for the production of an organic transistor according to the present embodiment of implementation of the invention comprises a step of forming a surface-treated layer on a gate insulating layer and a step of forming an organic semiconductor layer on the surface-treated layer, wherein a step of irradiating the gate insulating layer with ultraviolet rays in an ozone atmospherebefore the formation of the surface-treated layer is involved.

The aforementioned UV irradiation step is preferably conducted in an ozone concentration of from 10 to 1,000 ppm at an illumination intensity of at least 0.01 $mW/cm^2$ or more, preferably 0.05 $mW/cm^2$ or more, for an illumination time of 10 minutes or more.

Further, the formation of the surface-treated layer is preferably followed by the vacuum deposition of an organic semiconductor layer at a substrate temperature of from 40°C to 70°C. The mobility of the organic semiconductor layer is preferably 0.5 $cm^2/Vs$ or more.

Thus, in accordance with the process for the production of an organic transistor according to the present embodiment of implementation of the invention, a step of irradiating the gate insulating layer with ultraviolet rays in an ozone atmosphere before the formation of the surface-treated layer 16 is involved to produce a large number of hydroxyl groups necessary for surface treatment uniformly on the surface of the gate insulating layer, making it possible to effect homogeneous surface treatment and hence form an organic semiconductor layer having a high mobility and a good quality.

## Claims

1. A process for production of an organic transistor comprising:

   preparing a gate insulating layer;
   forming a surface-treated layer on the gate insulating layer; and
   forming an organic semiconductor layer on the surface-treated layer,

   wherein the gate insulating layer is irradiated with ultraviolet rays in an ozone atmosphere before the formation of the surface-treated layer.

2. The process according to Claim 1, wherein irradiating the gate insulating layer with ultraviolet rays is effected in an ozone concentration of from 10 to 1,000 ppm at an illumination intensity of 0.01 $mW/cm^2$ or more for an illumination time of 10 minutes or more.

3. The process according to Claim 2, wherein irradiating the gate insulating layer with ultraviolet rays is followed by the formation of the surface-treated layer by at least one compound selected from the group consisting of mono- or trichlorosilane compound having a functional group containing 8 or more carbon atoms represented by one of chemical formulas shown below, mono- or trialkoxysilane compound having a functional group containing 8 or more carbon atoms represented by one of chemical formulas shown below, and hexamethyldisilazalane,

   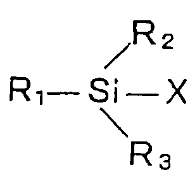
   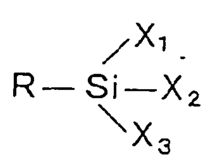

   where
   $R_1$ and R each independently represents a functional group having 8 or more carbon atoms containing hydrogen, oxygen, nitrogen, sulfur or halogen;
   X represents a chlorine atom, methoxy group or ethoxy group;
   $X_1$, $X_2$ and $X_3$ each independently represents a chlorine atom, methoxy group or ethoxy group; and
   $R_2$ and $R_3$ each independently represents an alkyl group having at least one carbon atoms.

4. The process according to Claim 3, wherein the surface treatment is followed by vacuum deposition of an organic semiconductor layer at a substrate temperature of from 40°C to 70°C.

**5.** The process according to Claim 4, wherein mobility of the organic semiconductor layer is 0.5 $cm^2/Vs$ or more.

**6.** An organic transistor comprising:

a substrate;
a gate electrode on the substrate;
a gate insulating layer on the substrate and the gate electrode;
an organic semiconductor layer on a surface of the gate insulating layer;
a source electrode on the organic semiconductor layer; and
a drain electrode on the organic semiconductor layer,

wherein the surface of the gate insulating layer on which the organic semiconductor layer is formed has a large number of hydroxyl groups uniformly.

**7.** The organic transistor according to Claim 6, wherein mobility of the organic semiconductor layer is 0.5 $cm^2/Vs$ or more.

**8.** An organic transistor comprising:

a substrate;
a gate electrode on the substrate;
a gate insulating layer on the substrate and the gate electrode;
a source electrode on the gate insulating layer;
a drain electrode on the gate insulating layer;
an organic semiconductor layer on a surface of the gate insulating layer;

wherein the surface of the gate insulating layer on which the organic semiconductor layer is formed has a large number of hydroxyl groups uniformly.

**9.** The organic transistor according to Claim 8, wherein mobility of the organic semiconductor layer is 0.5 $cm^2/Vs$ or more.

FIG. 1

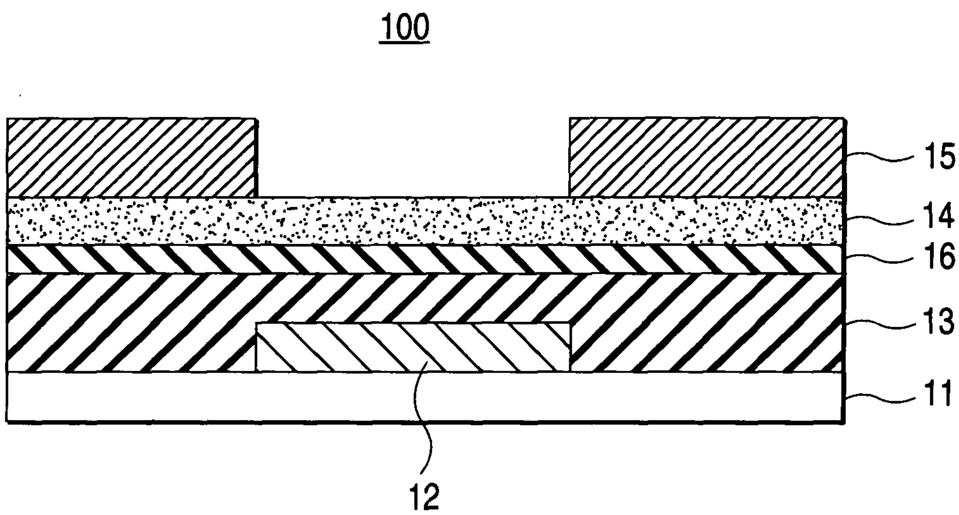

FIG. 2A

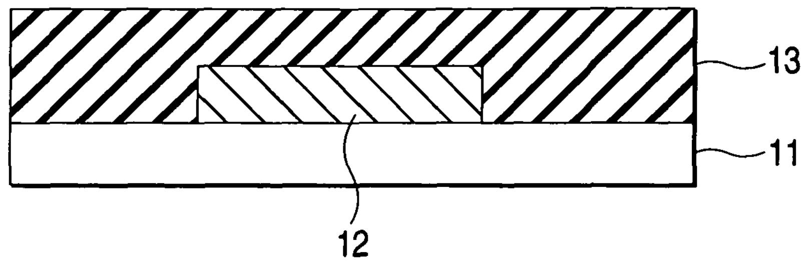


FIG. 2B

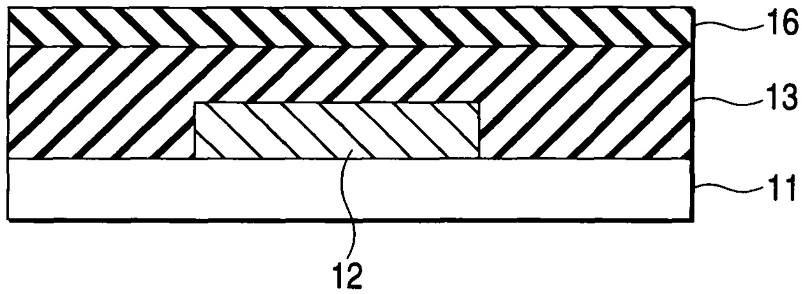


FIG. 2C

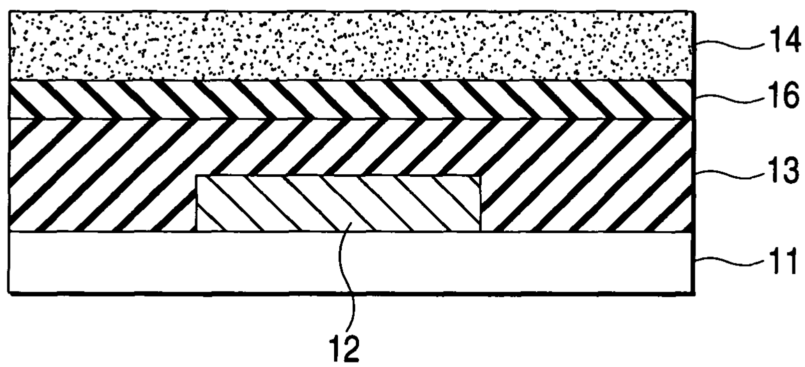


FIG. 2D

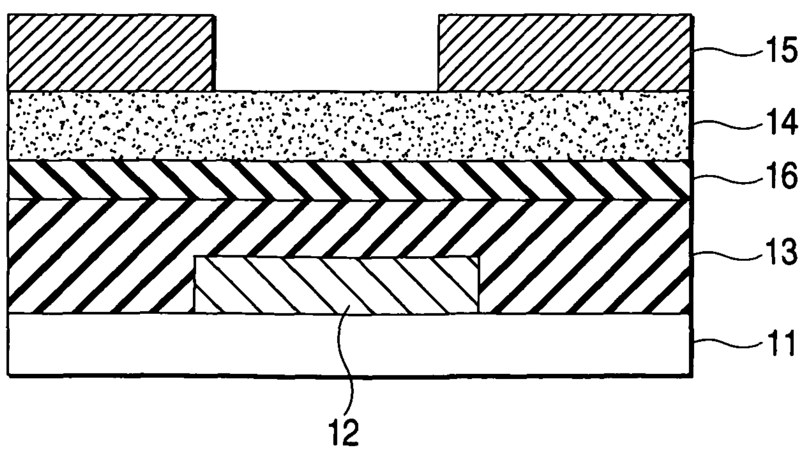

FIG. 3

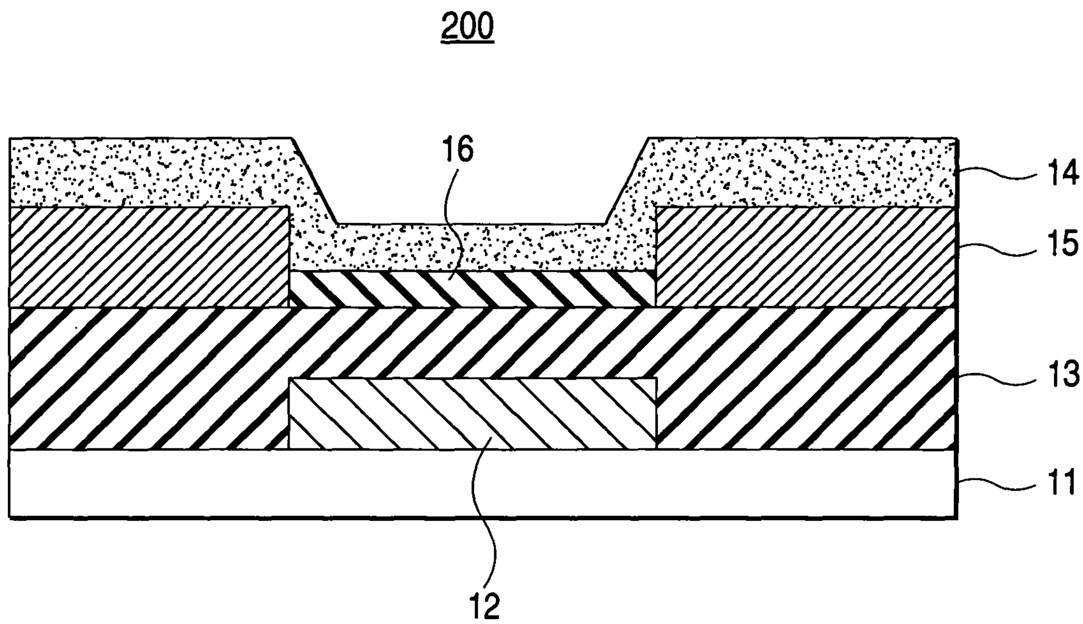

European Patent Office

## PARTIAL EUROPEAN SEARCH REPORT

which under Rule 45 of the European Patent Convention shall be considered, for the purposes of subsequent proceedings, as the European search report

Application Number EP 04 00 9729

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 179 863 A (MATSUSHITA ELECTRIC IND CO LTD) 13 February 2002 (2002-02-13)<br>* paragraph [0339] - paragraph [0342]; figures 20-24 * | 1,3,6,8 | H01L51/20 |
| X | US 6 433 359 B1 (MUYRES DAWN V ET AL) 13 August 2002 (2002-08-13)<br>* column 10, line 55 - column 11, line 52 * | 1,6,8 | |
| X | KLAUK H ET AL: "Pentacene thin film transistors and inverter circuits" ELECTRON DEVICES MEETING, 1997. TECHNICAL DIGEST., INTERNATIONAL WASHINGTON, DC, USA 7-10 DEC. 1997, NEW YORK, NY, USA,IEEE, US, 7 December 1997 (1997-12-07), pages 539-542, XP010265565<br>ISBN: 0-7803-4100-7<br>* the whole document * | 6-9 | |
| | -/-- | | |

TECHNICAL FIELDS SEARCHED (Int.Cl.7)

H01L
B05D

### INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| Munich | 21 July 2004 | Pusch, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C07)

European Patent Office

**INCOMPLETE SEARCH SHEET C**

Application Number
EP 04 00 9729

Claim(s) searched completely:
1 - 4

Claim(s) searched incompletely:
5 - 9

Reason for the limitation of the search:

Present claims 5, 7, and 9 relate to a method or a product defined by reference to a desirable property, namely a mobility of 0.5 cm2/Vs of the organic semiconductor. It is not clear, which specific method steps or device parameters result in the desired mobility.

The claims cover all methods or products having this characteristic or property, whereas the application provides support within the meaning of Article 84 EPC and/or disclosure within the meaning of Article 83 EPC for only a very limited number of such methods or products. In the present case, the claims so lack support, and the application so lacks disclosure, that a meaningful search over the whole of the claimed scope is impossible.
Independent of the above reasoning, the claims also lack clarity (Article 84 EPC). An attempt is made to define the method or product by reference to a specifi value of the mobility to be achieved. Again, this lack of clarity in the present case is such as to render a meaningful search over the whole of the claimed scope impossible. Consequently, the search has been carried out for those parts of the claims which appear to be clear, supported and disclosed, namely those parts relating to the semiconductor pentacene have been searched e.g. those prepared in examples (Examples 1- 5).

Furthermore, independent method claim 1 and independent product claims 6 and 8 as worded are not linked by a common concept. It is referred to irradiating the gate insulating layer with UV-rays in an ozone atmosphere in claim 1which according to the description (p. 4, l. 19 - 21) results in a large number of hydoxyl groups on the insulating layer as claimed in claims 6 and 8. However, as a consequence the subsequent forming of a surface treated layer in claim 1 the hydroxyl groups react with the substituted silanes and are no longer descernable in the transistor. Claims 6 and 8 have been searched in the light of method claim 1, that is comprising a "surface-treated layer" rather than a "gate insulating layer having a large number of hydroxyl groups uniformly".

European Patent Office

# PARTIAL EUROPEAN SEARCH REPORT

Application Number
EP 04 00 9729

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | SONG C-K: "EFFECTS OF HYDROPHOBIC TREATMENT ON THE PERFORMANCE OF PENTACENE TFT" KIEE INTERNATIONAL TRANSACTIONS ON ELECTROPHYSICS AND APPLICATIONS, XX, KR, vol. 12C, no. 2, 16 July 2001 (2001-07-16), pages 136-138, XP009012128 ISSN: 1598-2610 | 6,8 | |
| Y | * the whole document * | 1 | |
| Y | EP 1 132 147 A (MATSUSHITA ELECTRIC IND CO LTD) 12 September 2001 (2001-09-12) * paragraphs [0087], [0091], [0124] * | 1 | |
| A | MCINTYRE N S ET AL: "Uses of ultraviolet/ozone for hydrocarbon removal: applications to surfaces of complex composition or geometry" J. VAC. SCI. TECHNOL. A, VAC. SURF. FILMS (USA), JOURNAL OF VACUUM SCIENCE & TECHNOLOGY A (VACUUM, SURFACES, AND FILMS), MAY-JUNE 1991, USA, vol. 9, no. 3, pt.2, May 1991 (1991-05), - June 1991 (1991-06) pages 1355-1359, XP002289191 ISSN: 0734-2101 * the whole document * | 2 | TECHNICAL FIELDS SEARCHED (Int.Cl.7) |

EPO FORM 1503 03.82 (P04C10)

## ANNEX TO THE EUROPEAN SEARCH REPORT ON EUROPEAN PATENT APPLICATION NO. EP 04 00 9729

This annex lists the patent family members relating to the patent documents cited in the above-mentioned European search report.
The members are as contained in the European Patent Office EDP file on
The European Patent Office is in no way liable for these particulars which are merely given for the purpose of information.

21-07-2004

| Patent document cited in search report | Publication date | Patent family member(s) | Publication date |
|---|---|---|---|
| EP 1179863 A | 13-02-2002 | JP 2002057384 A | 22-02-2002 |
| | | JP 2002115079 A | 19-04-2002 |
| | | EP 1179863 A2 | 13-02-2002 |
| | | TW 515119 B | 21-12-2002 |
| | | US 2002057398 A1 | 16-05-2002 |
| US 6433359 B1 | 13-08-2002 | EP 1425806 A2 | 09-06-2004 |
| | | WO 03023877 A2 | 20-03-2003 |
| EP 1132147 A | 12-09-2001 | EP 1132147 A2 | 12-09-2001 |
| | | CN 1293614 T | 02-05-2001 |
| | | EP 1084822 A1 | 21-03-2001 |
| | | WO 0047403 A1 | 17-08-2000 |
| | | JP 2000297248 A | 24-10-2000 |
| | | JP 2000319594 A | 21-11-2000 |

EPO FORM P0459

For more details about this annex : see Official Journal of the European Patent Office, No. 12/82